# EUROPEAN PATENT APPLICATION

(11) **EP 4 749 913 A1**
(43) Date of publication of application: **27.05.2026**
(21) Application number: 24853520.5
(22) Date of filing: 23.07.2024
(51) Int. Cl.: H02P 27/08, H02M 7/00, H02K 7/20

(54) **MOTOR CONTROLLER, POWERTRAIN, AND VEHICLE**

(30) Priority: 16.08.2023 CN 202311041499
(71) Applicant: Huawei Digital Power Technologies Co., Ltd., Shenzhen, Guangdong 518043 (CN)
(72) Inventor: TAO, Hong, Shenzhen, Guangdong 518043 (CN); LIU, Bingbing, Shenzhen, Guangdong 518043 (CN); XU, Yankun, Shenzhen, Guangdong 518043 (CN); WANG, Yihe, Shenzhen, Guangdong 518043 (CN)
(74) Representative: Maiwald GmbH
(86) International application number: PCT/CN2024/107077
(87) International publication number: WO 2025/036108

(57) **Abstract**

This application relates to the field of motor control unit technologies, and in particular, to a motor control unit, a powertrain, and a vehicle. The motor control unit includes a circuit board, a plurality of power modules, a middle separator, two coolant pipes, and a capacitor module, each power module includes at least one power transistor, the circuit board is configured to control turn-on and turn-off of each power transistor, the middle separator includes an internal flow channel and two flow channel openings, and the two coolant pipes are separately communicated with the internal flow channel through the two flow channel openings; along a first direction, the plurality of power modules are arranged between the circuit board and the middle separator, the middle separator and the capacitor module are stacked, the middle separator includes two side surfaces distributed back to back, and the two flow channel openings are spaced from each other on one side surface of the middle separator; and along a second direction, the power module or the capacitor module is arranged between the two coolant pipes. The middle separator in the motor control unit provided in this application integrates functions of heat dissipation and power module installation, so that structure layout of the motor control unit is compact and integration is high.

## Description

### CROSS-REFERENCE TO RELATED APPLICATIONS

This application claims priority to Chinese Patent Application No. 202311041499.6, filed with the China National Intellectual Property Administration on August 16, 2023 and entitled "MOTOR CONTROL UNIT, POWERTRAIN, AND VEHICLE", which is incorporated herein by reference in its entirety.

### TECHNICAL FIELD

This application relates to the field of motor control unit technologies, and in particular, to a motor control unit, a powertrain, and a vehicle.

### BACKGROUND

A motor control unit is a core component for controlling an electric vehicle. As the electric vehicle has an increasingly high requirement on power density of a motor, a quantity of components in the motor control unit increases accordingly. However, in the conventional technology, integration of components in the motor control unit is low, resulting in a large volume of the motor control unit, and complex disassembly and assembly operations in a rework or repair process. Therefore, a new motor control unit with high integration and a small volume is urgently needed.

### SUMMARY

Embodiments of this application provide a motor control unit, a powertrain, and a vehicle. The motor control unit has compact layout, high integration, and small occupied space.

According to a first aspect, a motor control unit is provided. The motor control unit includes a circuit board, a plurality of power modules, a middle separator, two coolant pipes, and a capacitor module. The middle separator includes an internal flow channel, two flow channel openings, and two side surfaces. The two flow channel openings are spaced from each other on one side surface, and the two coolant pipes are separately communicated with the internal flow channel through the two flow channel openings. Along a first direction, the circuit board, the plurality of power modules, the middle separator, the two coolant pipes, and the capacitor module are stacked. The plurality of power modules are arranged between the circuit board and one side surface of the middle separator. Along a second direction, the power module or the capacitor module is arranged between the two coolant pipes. In this embodiment, the capacitor module is configured to perform filtering on a direct current, and output the filtered direct current to the power module. The power module converts the direct current into an alternating current, and outputs the alternating current to a motor. The circuit board is configured to control turn-on and turn-off of at least one power transistor included in the power module, and control the power module to convert a parameter of the alternating current. Coolant enters the internal flow channel of the middle separator through the coolant pipe to dissipate heat for the power module and the capacitor module. The middle separator integrates a heat dissipation function, so that integration of the motor control unit is higher and miniaturization of the motor control unit is facilitated. In addition, when the coolant enters the coolant pipe, heat can also be dissipated for the capacitor module or the power module, to improve a heat dissipation speed of the capacitor module or the power module.

In an embodiment, the middle separator includes a plurality of installation windows. Along the second direction, the plurality of installation windows are spaced from each other on the other side surface of the middle separator. Each installation window is used to fasten one power module, and each installation window is communicated with the internal flow channel. In this manner, the plurality of power modules are integrated into the other side surface of the middle separator through the installation windows on the middle separator, thereby improving integration of the middle separator, and further implementing miniaturization of the motor control unit.

In an embodiment, the middle separator includes two rows of circuit board supports for fastening the circuit board. The two rows of circuit board supports are distributed on the other side surface of the middle separator, and the two rows of circuit board supports and the plurality of installation windows are located on a same side of the middle separator. Along a third direction, the two rows of circuit board supports are oppositely arranged on two sides of the plurality of installation windows. The circuit board may be fastened via the two rows of circuit board supports included in the middle separator, so that functions integrated by the middle separator are further increased, to improve integration of the motor control unit, thereby miniaturizing the motor control unit.

In the foregoing embodiment, each row of circuit board supports includes four circuit board supports that are spaced from each other along the second direction, and a spacing between two adjacent circuit board supports is greater than an aperture of each installation window, so that when the circuit board supports fasten the circuit board to the middle separator, an edge of each power module can be further tightly pressed.

In an embodiment, each power module includes a plurality of direct current input copper bars, one alternating current output copper bar, and a plurality of power signal terminals. The plurality of direct current input copper bars are spaced from each other along the second direction. Along the third direction, the plurality of direct current input copper bars and the one alternating current output copper bar are respectively arranged on two sides of a power end. Each direct current input copper bar is configured to connect one power transistor and the capacitor module. A plurality of power signals extend along the first direction, and the power signal terminal is inserted into the circuit board to implement an electrical connection between the power module and the circuit board. The circuit board sends a control signal to the power module via the power signal terminal, so that the power module implements a function of alternating current-to-direct current conversion.

In an embodiment, the motor control unit includes a Hall component, and the Hall component is fastened to the other side surface of the middle separator. The Hall component includes a plurality of Hall sensors and a plurality of copper bar connecting pieces, and the plurality of Hall sensors are arranged on the other side surface of the middle separator along the second direction. Each Hall magnetic core includes a magnetic core through hole, each magnetic core through hole is configured to allow one copper bar connecting piece to penetrate, and the copper bar connecting piece is configured to connect to the power transistor and the motor, to transmit the alternating current to the motor. When the copper bar connecting piece penetrates through the magnetic core through hole, there is a gap between the copper bar connecting piece and an inner wall of the magnetic core through hole.

In an embodiment, the Hall component includes a Hall fastening plate. The middle separator includes at least one row of Hall supports arranged along the second direction, the at least one row of Hall supports is arranged on the other side surface of the middle separator, and the at least one row of Hall supports is configured to fasten the Hall fastening plate. An extension direction of the Hall fastening plate is parallel to the second direction, and the plurality of Hall magnetic cores are fastened to and arranged on the Hall fastening plate along the second direction.

In the foregoing embodiment, the Hall component is fastened via the Hall supports of the middle separator, so that functions integrated by the middle separator are further increased, to improve integration of the motor control unit, thereby miniaturizing the motor control unit.

In an embodiment, the capacitor module includes a capacitor housing, a capacitor core, and a plurality of direct current output copper bars. The capacitor housing is configured to accommodate the capacitor core, the plurality of direct current output copper bars are spaced from each other along the second direction, and the plurality of direct current output copper bars are configured to electrically connect the capacitor core and the power transistor. To reduce parasitic capacitance, a projection shape of at least one direct current output copper bar along the first direction includes an S shape or a U shape.

In an embodiment, the direct current output copper bar includes a welding section, a plurality of bent sections, and a lead-out section, and the plurality bent sections are sequentially connected between the welding section and the lead-out end. The welding section is configured to electrically connect to a direct current input copper bar of the one power module, and the lead-out section is configured to electrically connect to the capacitor core. A bending direction of at least one bent section in the plurality of bent sections is different from a bending direction of at least one bent section in the plurality of bent sections, so that mechanical stress of the welding section included in the output copper bar can be reduced, stability of a connection between the output copper bar and the input copper bar can be improved, and operating stability of the motor control unit can be improved.

In an embodiment, the plurality of bent sections include a first bent section, and the first bent section includes two first connection sections. One first connection section is configured to connect to the welding section, the other first connection section is configured to connect to another bent section, and an included angle between the one first connection section and the other first connection section faces the one power module, so that installation space on a side that is of the capacitor module and that faces the power module is larger, thereby facilitating device layout. Alternatively, an included angle between the one first connection section and the other first connection section faces away from the one power module, so as to prevent the two first connection sections and the another bent section from protruding from the capacitor module, and improve compactness of the motor control unit.

In an embodiment, the welding section and the one first connection section are separately stacked with one direct current input copper bar along the first direction. The direct current input copper bar is separately stacked with the welding section and the one first connection section, so that parasitic capacitance can be reduced.

In an embodiment, the plurality of bent sections include a second bent section, and the second bent section includes two second connection sections. One second connection section is configured to connect to the lead-out section, the other second connection section is configured to connect to another bent section, and an included angle direction between the one second connection section and the other second connection section faces the one power module, so that installation space on a side that is of the capacitor module and that faces the power module is larger, thereby facilitating device layout. Alternatively, an included angle direction between the one second connection section and the other second connection section faces away from the one power module, so as to prevent the two second connection sections from protruding from the capacitor module, and improve compactness of the motor control unit.

In an embodiment, to protect the circuit board, the motor control unit includes a protective cover. Along the first direction, the protective cover is located on a side that is of the circuit board and that faces away from the power module, and covers the circuit board.

According to a second aspect, an embodiment of this application provides a powertrain. The powertrain includes a motor and the motor control unit according to any technical solution in the first aspect, and the motor control unit is electrically connected to the motor. The motor control unit is configured to: convert a direct current provided by a power supply into an alternating current, and output the alternating current to the motor.

According to a third aspect, an embodiment of this application provides a vehicle. The vehicle includes a vehicle body, a motor, and the motor control unit in any technical solution in the first aspect, or includes the powertrain in the second aspect. The motor or the powertrain is installed on the vehicle body, and the motor or the powertrain is used to drive the vehicle.

### BRIEF DESCRIPTION OF DRAWINGS

FIG. 1 is a diagram of a structure of a vehicle according to an embodiment of this application;
FIG. 2 is a diagram of an application scenario of a powertrain according to an embodiment of this application;
FIG. 3 is an overall assembly diagram of a motor control unit according to an embodiment of this application;
FIG. 4 is an exploded view of a motor control unit according to an embodiment of this application;
FIG. 5 is a diagram of a structure of a middle separator in a motor control unit according to an embodiment of this application;
FIG. 6 is an exploded view of FIG. 5;
FIG. 7 is a bottom view of FIG. 5;
FIG. 8 is a diagram of a structure of a mainboard of a middle separator in a motor control unit according to an embodiment of this application;
FIG. 9 is a diagram of a structure of a cover plate of a middle separator in a motor control unit according to an embodiment of this application;
FIG. 10 is a diagram of a structure of a capacitor module in a motor control unit according to an embodiment of this application;
FIG. 11 is a diagram of a structure of matching between a capacitor module and a power module in a motor control unit according to an embodiment of this application;
FIG. 12 is a side view of FIG. 11;
FIG. 13 is still another side view of matching between a capacitor module and a power module in a motor control unit according to an embodiment of this application;
FIG. 14 is still another side view of matching between a capacitor module and a power module in a motor control unit according to an embodiment of this application;
FIG. 15 is a diagram of a structure of a pressure plate in a motor control unit according to an embodiment of this application;
FIG. 16 is a diagram of a structure of a motor control unit according to an embodiment of this application; and
FIG. 17 is a diagram of another structure of a motor control unit according to an embodiment of this application.

### Reference numerals:

1-vehicle; 11-wheel; 12-vehicle-mounted load; 13-external power supply; 2-powertrain; 20-power supply module; 21-power battery; 22-motor; 3-motor control unit; 30-middle separator; 30a-flow channel opening; 30b-installation window; 30c-positioning hole; 30d-mainboard; 30e-cover plate; 300-circuit board support; 301-pressure plate fastener; 302-Hall support; 303-capacitor module connecting piece, 304-coolant accommodating groove, 305-positioning plate; 306-positioning slot; 307-separator; 310-coolant pipe; 32-power module; 320-power transistor; 321-direct current input copper bar; 322-alternating current output copper bar; 323-power signal terminal; 33-circuit board; 330-circuit board fastening hole; 34-capacitor module; 340-capacitor housing; 341-capacitor core; 342-direct current output copper bar; 3420-groove; 3421-welding section; 3422-bent section; 3422a-first bent section; 3422b-second bent section; 34220-first connection section; 34221-second connection section; 3423-lead-out section; 343-positioning portion; 344-insulation plate; 35-pressure plate component; 350-pressure plate; 3500-pressure plate fastening hole; 351-insulation paper; 36-protective cover; 37-Hall component; 370-Hall fastening plate; 371-Hall magnetic core; 372-copper bar connecting piece; 373-connecting copper bar.

### DESCRIPTION OF EMBODIMENTS

To make the objectives, technical solutions, and advantages of this application clearer, the following further describes this application in detail with reference to the accompanying drawings.

A motor control unit is a core component for controlling an electric vehicle. As the electric vehicle has an increasingly high requirement on power density of a motor, a quantity of components in the motor control unit increases accordingly. However, in a conventional technology, integration of components in the motor control unit is low, resulting in a large volume of the motor control unit, and complex disassembly and assembly operations in a rework or repair process. Therefore, a new motor control unit with high integration and a small volume is urgently needed.

Terms used in the following embodiments are merely intended to describe specific embodiments, but are not intended to limit this application. The terms "one", "a" and "this" of singular forms used in this specification and the appended claims of this application are also intended to include expressions such as "one or more", unless otherwise specified in the context clearly.

Reference to "an embodiment", "some embodiments", or the like described in this specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

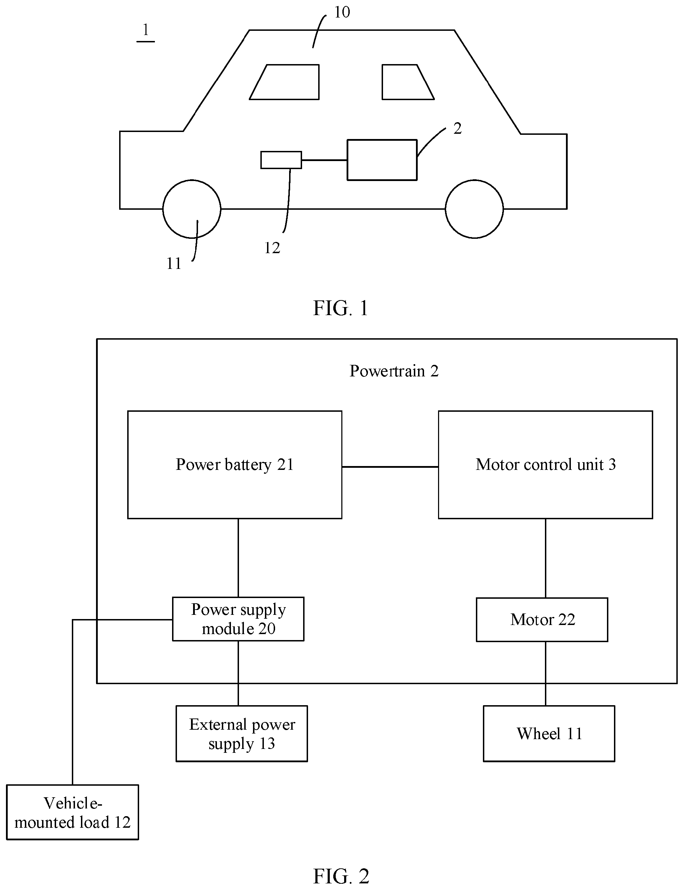

FIG. 1 is a diagram of a structure of a vehicle 1 according to an embodiment of this application. In an implementation, the vehicle 1 includes a vehicle body 10, wheels 11, and a powertrain 2. The powertrain 2 is installed on the vehicle body 10, and is configured to supply power to a vehicle-mounted load 12 and drive the wheels 11 to rotate.

In this implementation, the vehicle 1 is a wheeled vehicle 1 that is driven or guided by a power apparatus and is used for passengers traveling on a road or for transporting articles and performing special engineering operations. The vehicle 1 includes an electric vehicle (Electric Vehicle, EV), a battery electric vehicle (Battery Electric Vehicle, BEV), a hybrid electric vehicle (Hybrid Electric Vehicle, HEV), a range extended electric vehicle (Range Extended Electric Vehicle, REEV), a plug-in hybrid electric vehicle (Plug-in Hybrid Electric Vehicle, PHEV), or a new energy vehicle (New Energy Vehicle).

FIG. 2 is a diagram of a powertrain 2 according to an embodiment of this application. In an implementation, the powertrain 2 includes a power supply module 20, a power battery 21, a motor control unit 3, and a motor 22.

In this implementation, the power supply module 20 receives power supplied by an external power supply 13, and charge the power battery 21. The external power supply 13 may be an alternating current power grid, an alternating current charging pile, or a direct current charging pile. The power battery 21 supplies power to the motor 22 via the motor control unit 3. The motor control unit 3 is electrically connected to the motor 22. The motor control unit 3 is configured to convert a direct current provided by the power battery 21 into an alternating current. The motor 22 receives the alternating current and converts the alternating current into kinetic energy to drive the wheels 11 to run.

In an implementation, the power supply module 20 is electrically connected to the vehicle-mounted load 12. The power supply module 20 is configured to supply power to the vehicle-mounted load 12. The power supply module 20 may be a power distribution unit or a vehicle-mounted charger. The vehicle-mounted load 12 includes at least one of a compressor, a battery heating module, a seat heating module, and a direct current low voltage power supply.

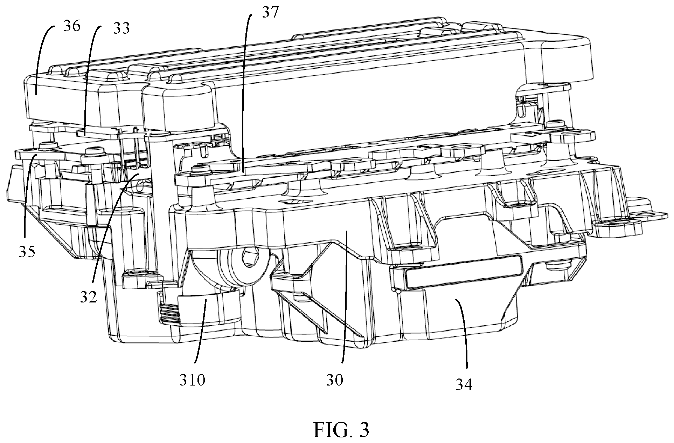

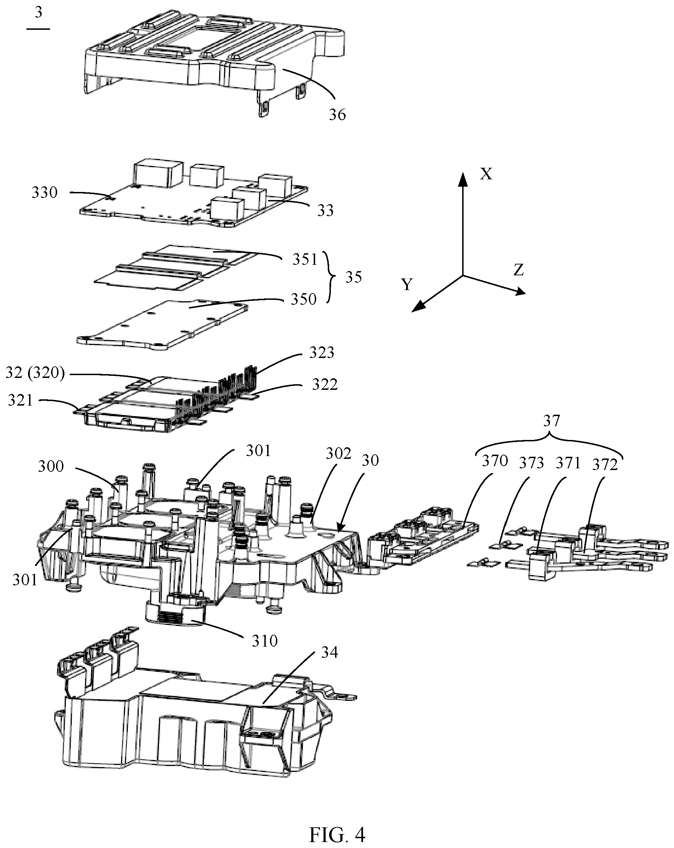

FIG. 3 is an overall assembly diagram of a motor control unit according to an embodiment of this application. FIG. 4 is an exploded view of a motor control unit according to an embodiment of this application. Refer to FIG. 3 and FIG. 4. The motor control unit includes a circuit board 33, a plurality of power modules 32, a middle separator 30, two coolant pipes 310, a capacitor module 34, a pressure plate component 35, a protective cover 36, and a Hall component 37.

The capacitor module 34 is configured to perform filtering on a direct current, and output a filtered direct current to the power module 32. The power module 32 converts the direct current into an alternating current and outputs the alternating current to a motor. The circuit board 33 is configured to control turn-on and turn-off of a plurality of switching transistors in the plurality of power modules 32, and control the power module 32 to convert a parameter of the alternating current. The Hall component 37 is configured to detect parameters of alternating currents output by the plurality of power modules 32, and transmit the detected parameters of the alternating currents to the circuit board 33. The middle separator 30 is configured to fasten one or more of the circuit board 33, the plurality of power modules 32, the two coolant pipes 310, the capacitor module 34, the pressure plate component 35, the protective cover 36, or the Hall component 37.

In an embodiment, along a first direction X, the circuit board 33, the pressure plate component 35, the plurality of power modules 32, the middle separator 30, and the capacitor module 34 are stacked. The two coolant pipes 310 are communicated with a side surface that is of the middle separator 30 and that faces the capacitor module 34. The Hall component 37 is installed on a side surface that is of the middle separator 30 and that faces the power module 32. The protective cover 36 is configured to cover the circuit board 33, to prevent the circuit board 33 from being damaged by an external component or external force.

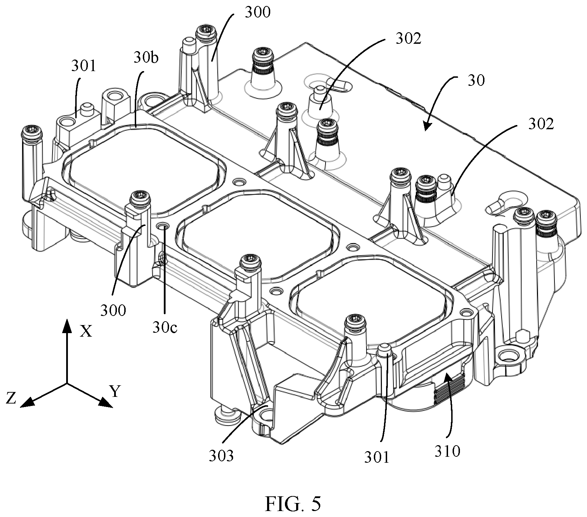

FIG. 5 is a diagram of a structure of a middle separator in a motor control unit according to an embodiment of this application. Refer to FIG. 4 and FIG. 5, the middle separator 30 includes a plurality of installation windows 30b. Along a second direction Y, the plurality of installation windows 30b are spaced from each other on one side surface of the middle separator 30.

In an embodiment, the plurality of installation windows 30b are located on a side surface that is of the middle separator 30 and that faces away from the capacitor module.

Each installation window 30b is configured to fasten one power module 32. Each installation window 30b is communicated with an internal flow channel of the middle separator 30, so that heat generated when the power module 32 operates can be quickly dissipated through the installation window 30b, thereby ensuring operating stability of the power module 32.

In an embodiment, the power module 32 is installed on each installation window 30b, and a sealing ring may be further installed between the power module 32 and the installation window 30b, to improve sealing performance of installing the power module on the installation window 30b and prevent coolant leakage.

In this embodiment of this application, a shape of each installation window 30b includes a rectangle, a circle, a rhombus, or the like. In an embodiment, shapes of the installation windows 30b may be the same or may be different.

Still refer to FIG. 4 and FIG. 5. The middle separator 30 includes two rows of circuit board supports 300. In an embodiment, the two rows of circuit board supports 300 and the plurality of installation windows 30b are distributed on a same side surface of the middle separator 30. Along a third direction Z, the two rows of circuit board supports 300 are oppositely arranged on two sides of the plurality of installation windows 30b, and the two rows of circuit board supports 300 are configured to fasten the circuit board 33.

In an embodiment, the plurality of installation windows 30b are located between the two rows of circuit board supports 300.

In this embodiment of this application, the circuit board 33 may be fastened via the circuit board supports 300 of the middle separator 30, so that functions integrated by the middle separator 30 are further increased, to improve integration of the motor control unit, thereby miniaturizing the motor control unit.

In an embodiment, each row of circuit board supports 300 includes four circuit board supports 300, and the four circuit board supports 300 are spaced from each other along the second direction Y. A spacing between two adjacent circuit board supports 300 is greater than an aperture of each installation window 30b. On a projection along the second direction Y, there is one installation window 30b arranged between two adjacent circuit board supports 300. Because the circuit board and the power module are stacked along the first direction X, the circuit board 33 may be installed on the middle separator 30 via the circuit board supports 300, and four circuit board supports 300 around each installation window 30b can tightly press corners of the installation window 30b, thereby improving compactness of installing each power module 32 on the installation window 30b.

Still refer to FIG. 4 and FIG. 5. The middle separator 30 includes two rows of pressure plate fasteners 301, and the two rows of pressure plate fasteners 301 are configured to fasten the pressure plate component 35 to the middle separator 30. In an embodiment, the two rows of pressure plate fasteners 301, the circuit board supports 300, and the installation windows 30b are installed on a same side surface of the middle separator 30. Along the second direction Y, the two rows of pressure plate fasteners 301 are oppositely arranged on two sides of the plurality of installation windows 30b, and along the first direction X, the plurality of power modules 32 are arranged between the pressure plate component 35 and the middle separator 30. The pressure plate fasteners 301 fasten the pressure plate component 35 to the middle separator 30. This can improve stability of installing the power module on the installation window and prevent coolant leakage.

In this embodiment of this application, the pressure plate component 35 may be fastened via the pressure plate fastener 301 of the middle separator 30, so that functions integrated by the middle separator 30 are further increased, to improve integration of the motor control unit, thereby miniaturizing the motor control unit.

Still refer to FIG. 4 and FIG. 5. The middle separator 30 includes two rows of positioning holes 30c. In an embodiment, each row of positioning holes 30c includes a plurality of positioning holes 30c that are spaced from each other along the second direction Y. Along the third direction Z, two positioning holes 30c are arranged between at least some two circuit board supports 300 that are opposite to each other. Two positioning holes 30c are arranged between every two adjacent installation windows 30b, and the two positioning holes 30c are spaced from each other along the third direction. A connecting piece penetrates through the pressure plate component 35 to match the positioning hole 30c. When the connecting piece and the pressure plate fastener 301 fasten the pressure plate component, the connecting piece and the pressure plate fastener 301 can tightly press corners of each installation window 30b, to further improve stability of a connection between the pressure plate component and the middle separator 30, and can also tightly press the power module 32. In an embodiment, matching between the connecting piece and the positioning hole 30c may also be understood as the pressure plate fastener.

Still refer to FIG. 4 and FIG. 5. The middle separator 30 includes at least one row of Hall supports 302 arranged along the second direction. The Hall supports 302, the pressure plate fasteners 301, the installation windows 30b, and the circuit board supports 300 are all located on a same side of the middle separator 30. Each row of Hall supports 302 includes at least two Hall supports 302. The Hall supports 302 are configured to fasten the Hall component to the middle separator 30, to improve integration of the middle separator 30 and miniaturize the motor control unit. In an embodiment, the middle separator 30 includes a capacitor module connecting piece 303 configured to connect to the capacitor module, so that stability is higher when the capacitor module matches the middle separator 30.

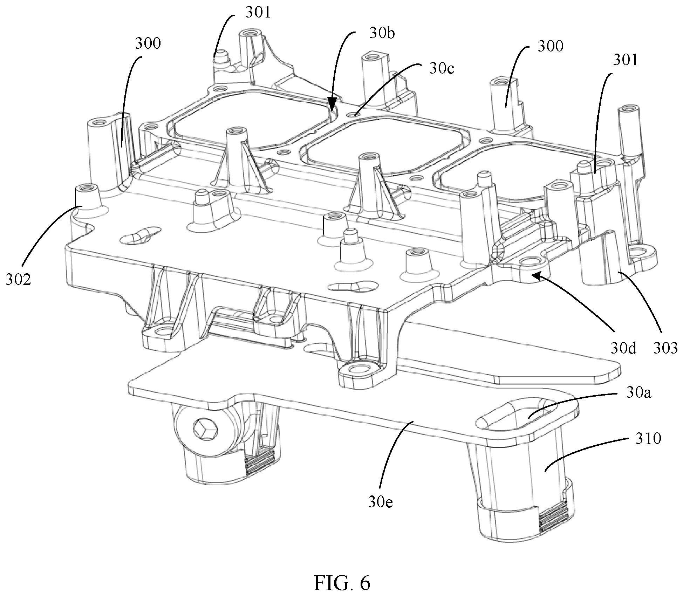

FIG. 6 is an exploded view of FIG. 5. Refer to FIG. 5 and FIG. 6. The middle separator 30 includes a mainboard 30d and a cover plate 30e. In an embodiment, a material of the mainboard 30d is aluminum alloy, and the mainboard 30d is an aluminum alloy sealed die casting part. Along the first direction X, the mainboard 30d has a first face and a second face that are opposite to each other, and the cover plate 30e and the second face of the mainboard 30d are integrally formed through friction welding. The first face of the mainboard 30d is configured to integrate the plurality of installation windows 30b, the two rows of circuit board supports 300, the at least one row of Hall supports 302, and the two rows of pressure plate fasteners 301. The first face of the mainboard 30d includes the two rows of positioning holes 30c, and along the second direction, the two rows of positioning holes 30c are arranged between two adjacent installation windows 30b. Along the third direction, the two rows of positioning holes 30c are arranged between the two rows of circuit board supports 300. The capacitor module connecting piece 303 is integrated on a side surface of the mainboard 30d. The side surface is a connecting surface that is of the mainboard 30d and that is used to connect the first face and the second face, and along the first direction X, the capacitor module connecting piece 303 extends to one side of the cover plate 30e.

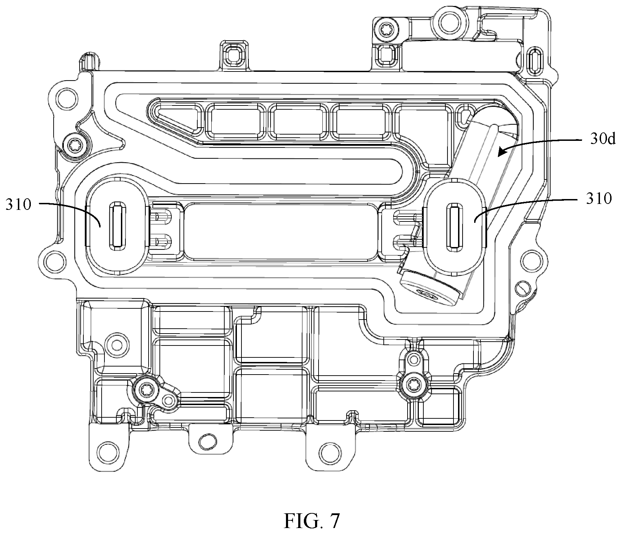

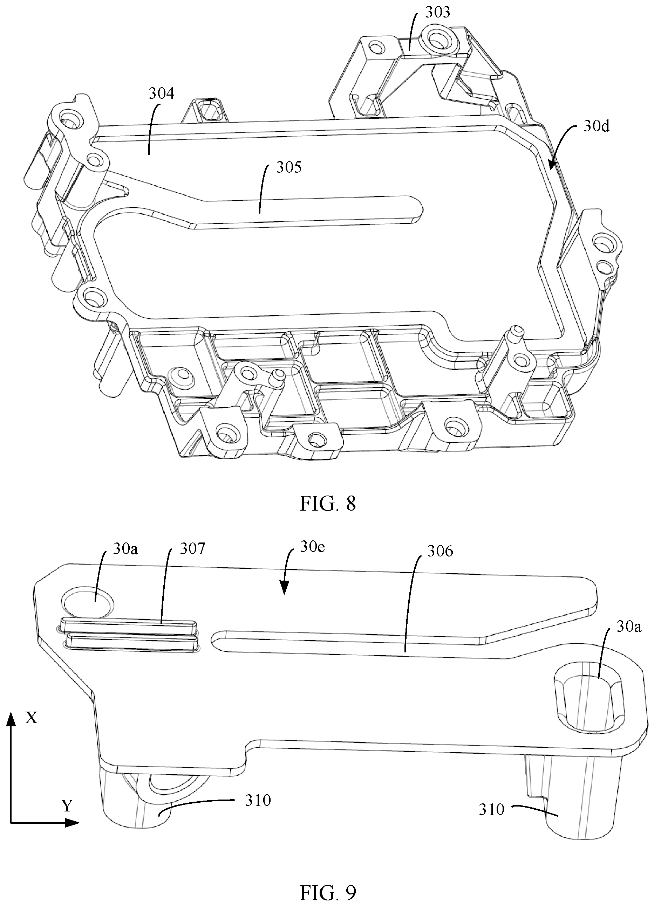

FIG. 7 is a bottom view of a middle separator in a motor control unit according to an embodiment of this application. FIG. 8 is a diagram of a structure of a mainboard of a middle separator in a motor control unit according to an embodiment of this application. FIG. 9 is a diagram of a structure of a cover plate of a middle separator in a motor control unit according to an embodiment of this application. Still refer to FIG. 6 to FIG. 9. The second face of the mainboard 30d includes a coolant accommodating groove 304, and an edge of the coolant accommodating groove 304 is located at an edge of the mainboard 30d, so that a capacity of the coolant accommodating groove 304 is large, and heat dissipation effect is ensured. A positioning plate 305 is integrated on the second face of the mainboard 30d, the positioning plate 305 is located in the coolant accommodating groove 304, one end of the positioning plate 305 is connected to one side wall of the coolant accommodating groove 304, and the other end of the positioning plate 305 extends to one side of the other side wall of the coolant accommodating groove 304. The positioning plate 305 is not connected to the other side wall of the coolant accommodating groove 304. The positioning plate 305 is disposed and spaced from the other side wall of the coolant accommodating groove 304, so that the positioning plate 305 separates the coolant accommodating groove 304 into two intercommunicated parts. A side that is of the cover plate 30e and that faces the mainboard 30d includes a positioning slot 306 and at least one separator 307. The positioning slot 306 penetrates through the cover plate 30e along the first direction X, and along the second direction Y, the at least one separator 307 and the positioning slot 306 are spaced from each other. Two flow channel openings 30a on the mainboard 30d are respectively arranged on two sides of the separator 307 and the positioning slot 306. The two coolant pipes 310 are communicated with the two flow channel openings 30a, so that pipe openings of the two coolant pipes 310 are far away from each other, thereby increasing time for coolant to stay in the middle separator 30, and improving heat dissipation effect of the middle separator.

In an embodiment, the cover plate 30e is fastened on the second face of the mainboard 30d through friction welding. The positioning slot 306 matches the positioning plate 305 through clamping. The entire cover plate 30e is located in the coolant accommodating groove 304, and all edges of the coolant accommodating groove 304 are sealed through friction welding, so that an internal flow channel is formed between the cover plate 30e and the second face of the mainboard 30d. The internal flow channel is communicated with each installation window 30b, and coolant in the internal flow channel is input and discharged through the two coolant pipes 310. To ensure that the coolant stays in the internal flow channel for a long time, the coolant fully exchanges heat with another component. A quantity of separators 307 may be two, the two separators 307 are parallel, and the two separators 307 extend along the second direction Y, to slow down a speed of the coolant flowing in the internal flow channel. In this embodiment of this application, along the first direction X, a height of the separator 307 is the same as a height of the positioning plate 305, to ensure airtightness of the internal flow channel formed after the cover plate 30e is welded to the mainboard 30d.

In an embodiment, to improve heat dissipation performance of the middle separator 30 for the capacitor module 34, a thermal pad may be disposed between the cover plate 30e and the capacitor module 34.

In an embodiment, shapes of the two flow channel openings 30a may be a circle, a rectangle, a diamond, or another irregular pattern. A diameter of an inlet in the flow channel opening 30a may be greater than a diameter of an outlet, so that the coolant can stay in the internal flow channel for a long time, thereby improving heat exchange efficiency. The diameter of the inlet in the flow channel opening 30a may be less than the diameter of the outlet, and the coolant stays in the internal flow channel for a short time, so that the coolant can quickly enter the internal flow channel.

In an embodiment, a shape of a coolant channel included in the coolant pipe 310 may be a cylinder, a prism, or the like. A diameter of the coolant pipe 310 is greater than that of the flow channel opening 30a, to improve sealing performance of a connection between the coolant pipe 310 and the flow channel opening 30a.

Still refer to FIG. 4. Each power module 32 includes at least one power transistor 320. The circuit board 33 is configured to control turn-on and turn-off of each power transistor 320, and the power module 32 implements an alternating current-direct current conversion function. The power module 32 is installed on the middle separator 30 through the installation window, and the middle separator 30 dissipates heat for the power transistor 320 included in the power module 32, to ensure that the power module 32 can operate stably.

In an embodiment, the power module 32 includes a plurality of power transistors 320. The plurality of power transistors 320 in the power module 32 are used to form a three-phase bridge arm circuit. The plurality of power transistors 320 in the power module 32 are arranged in a flat manner along the second direction Y on a side that is of the middle separator 30 and that faces away from the capacitor module 34. For example, each power module 32 includes two power transistors 320, and every two power transistors 320 form one-phase bridge arm circuit. Two ends of each-phase bridge arm circuit are electrically connected to the capacitor module 34. In an implementation, the two power transistors 320 are arranged in two rows in a flat manner along the second direction Y. In an implementation, the two power transistors 320 are arranged in a single row in a flat manner along the second direction Y.

In an embodiment, the plurality of power modules 32 are used to form a three-phase bridge arm circuit. The plurality of power modules 32 are arranged in a flat manner along the second direction. For example, the motor control unit 3 includes three power modules 32. Each power module 32 forms one-phase bridge arm circuit. Two ends of each-phase bridge arm circuit are electrically connected to the capacitor module 34.

Each power module 32 includes an upper bridge arm switching transistor and a lower bridge arm switching transistor. The upper bridge arm switching transistor and the lower bridge arm switching transistor each include at least one power transistor 320. In an embodiment, each power module 32 includes two power transistors 320. The two power transistors 320 separately form an upper bridge arm switching transistor and a lower bridge arm switching transistor of one-phase bridge arm circuit.

In an embodiment, the power transistor 320 includes at least one of an insulated gate bipolar transistor (Insulated Gate Bipolar Transistor, IGBT) or a metal-oxide semiconductor field-effect transistor (Metal-Oxide-Semiconductor Field-Effect Transistor, MOS). In an embodiment, the power transistor 320 includes a silicon carbide metal-oxide-semiconductor field-effect transistor (silicon carbide metal-oxide-semiconductor field-effect transistor, SiC MOSFET) or a silicon-insulated-gate bipolar transistor (silicon-insulated-gate bipolar transistors, Si IGBT).

In this implementation, the plurality of power modules 32 are arranged in a flat manner along the second direction on a surface of the middle separator 30. Compared with the manner in which the plurality of power modules 32 are stacked between the pressure plate component 35 and the middle separator 30 along the first direction, this manner in this solution helps reduce a length of the motor control unit 3 along the first direction, effectively utilizes an installation area of the middle separator 30, and can implement a miniaturization design of the motor control unit.

In an embodiment, a heat sink fin portion (not shown in the figure) is provided on a side that is of each power module and that faces the middle separator. The side that is of the power module and that has the heat sink fin portion is sealed and connected to an installation window via a sealing ring, to ensure that the middle separator can dissipate heat for the power module, also ensure that the coolant does not leak, and prevent another component from being damaged.

In an embodiment, the power module and the middle separator may be pre-assembled, so that parts inside the motor control unit are modularized. When the motor control unit needs to be reworked or repaired, the parts do not need to be disassembled and assembled one by one, thereby implementing quick assembly and disassembly of the motor control unit, and reducing operation difficulty and costs.

Still refer to FIG. 4. Each power module 32 includes a plurality of direct current input copper bars 321 and a plurality of alternating current output copper bars 322. The plurality of direct current input copper bars 321 are spaced from each other along the second direction. Along the third direction, the plurality of direct current input copper bars 321 and one alternating current output copper bar 322 are respectively arranged on two sides of the power transistor 320. Each direct current input copper bar 321 is configured to connect one power transistor 320 and the capacitor module 34. The power transistor 320 is electrically connected to the capacitor module 34 via the direct current input copper bar 321. A direct current is transmitted from the capacitor module 34 to the power transistor 320 via the direct current input copper bar 321, and the plurality of direct current input copper bars 321 extend to an outer side of the middle separator 30, so that the direct current input copper bars 321 are electrically connected to the capacitor module 34.

In this embodiment of this application, each power module 32 includes three direct current input copper bars 321, and each power module 32 includes one alternating current output copper bar. In some other implementations, each power module may include another positive integer quantity of direct current input copper bars 321, and a person skilled in the art may adjust the quantity based on an actual requirement. This is not limited in this application.

Still refer to FIG. 4. Each power module 32 includes a power signal terminal 323. The power signal terminal 323 is located on a side that is of the power module 32 and that is opposite to the direct current input copper bar 321 and extends to the circuit board 33. In an embodiment, the power signal terminal 323 is a pin, and the power signal terminal 323 is inserted into the circuit board to implement an electrical connection between the power module 32 and the circuit board 33. The circuit board 33 sends a control signal to the power module 32 via the power signal terminal 323, so that the power module 32 implements a function of alternating current-to-direct current conversion.

Still refer to FIG. 4. The capacitor module 34 is configured to transmit the direct current and adjust the direct current, including but not limited to smoothing a voltage, so that a voltage is still smooth when a switching device in the power module 32 is switched on or switched off. The capacitor module 34 may further reduce an inductance parameter, weaken a peak voltage, absorb a high pulse current of the motor control unit 3, and prevent impact of voltage overcharge and impact of a transient voltage on the motor control unit 3.

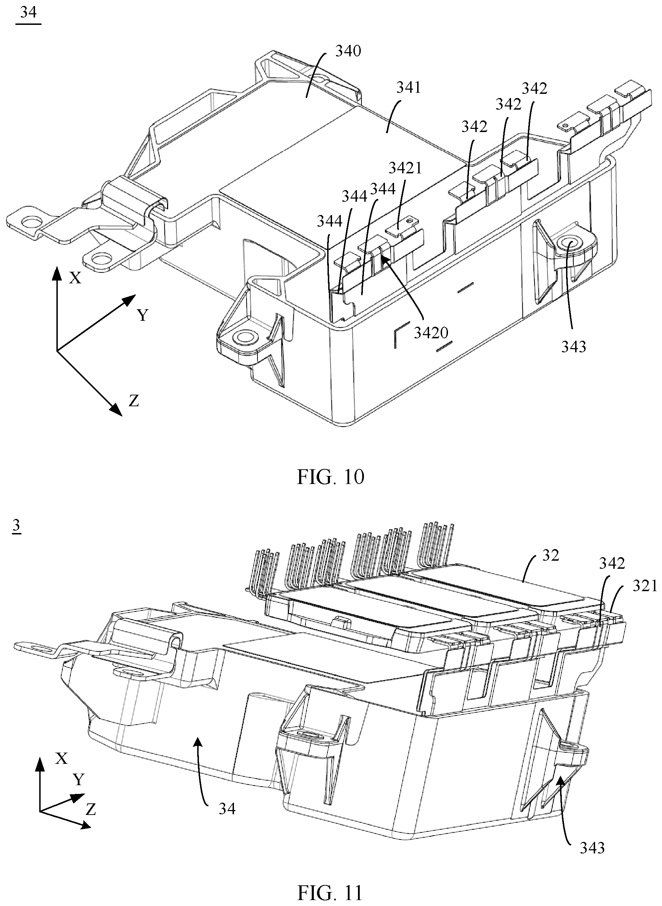

FIG. 10 is a diagram of a structure of a capacitor module in a motor control unit according to an embodiment of this application. FIG. 11 is a diagram of a structure of matching between a capacitor module and a power module in a motor control unit according to an embodiment of this application. Refer to FIG. 4, FIG. 10, and FIG. 11. The capacitor module 34 includes a capacitor core 341, a capacitor housing 340, and a plurality of direct current output copper bars 342. The capacitor housing 340 includes a plurality of positioning portions 343, and the positioning portion 343 is configured to match the capacitor module connecting piece 303 included in the middle separator, so that the capacitor housing 340 is fastened to the middle separator 30. The capacitor housing 340 is configured to accommodate the capacitor core 341, and one direct current output copper bar 342 is configured to connect to one power transistor 320. The plurality of direct current output copper bars 342 are arranged along the second direction Y on a side that is of the capacitor module 34 and that faces the middle separator 30, and orthographic projections of the direct current output copper bars 342 and the middle separator 30 on an installation surface of the capacitor module 34 do not overlap. The installation surface of the capacitor module 34 is a surface that is of the capacitor housing 340 and that faces the power module 32. The direct current input copper bar 321 is electrically connected to the direct current output copper bar 342. The power transistor 320 is electrically connected to the capacitor module 34 via the direct current input copper bar 321 and the direct current output copper bar 342. The direct current is transmitted from the capacitor module 34 to the power transistor 320 via the direct current output copper bar 342 and the direct current input copper bar 321.

In an embodiment, the installation surface of the capacitor module 34 may be understood as a surface that is of the capacitor housing 340 and that faces the middle separator 30. The direct current output copper bar 342 extends out of the installation surface along the first direction, and orthographic projections of the direct current output copper bar 342 and the installation surface of the power transistor 320 do not overlap. The direct current input copper bar 321 extends from the power transistor along the third direction Z, where the third direction Z is perpendicular to the first direction X and the second direction Y respectively, and the direct current input copper bar 321 and the direct current output copper bar 342 overlap along the first direction X. It may be understood that the direct current input copper bar 321 is disposed along a horizontal direction (the third direction Z), and the direct current output copper bar 342 is disposed along the second direction Y. The direct current input copper bar 321 and the direct current output copper bar 342 are fastened through laser welding.

In an embodiment, the plurality of direct current output copper bars 342 form three groups of direct current output copper bars 342. Each group of direct current output copper bars 342 includes two positive output copper bars 342 and one negative output copper bar 342. Along the second direction Y, the one negative output copper bar 342 is located between the two positive output copper bars 342. It may be understood that, in three direct current output copper bars 342 included in each group of direct current output copper bars 342, along the second direction Y, a direct current output copper bar 342 located in the middle is the negative direct current output copper bar 342, and direct current output copper bars 342 located on both sides are the positive output copper bars 342.

Still refer to FIG. 10 and FIG. 11. The capacitor module includes three insulation plate groups. Each insulation plate group includes three insulation plates 344 spaced from each other along the third direction, the two positive output copper bars 342 are located between two adjacent insulation plates 344 in the three insulation plates 344, and the one negative output copper bar 342 is located between another two adjacent insulation plates 344. The two positive output copper bars 342 and the one negative output copper bar 342 are all connected to the capacitor core 341, and a projection of at least one copper bar in the two positive output copper bars 342 and the one negative output copper bar 342 along the first direction may be in an S shape or a U shape, to reduce parasitic inductance. In an embodiment, to reduce stress of the negative output copper bar 342, the negative output copper bar 342 includes a groove 3420, and the groove 3420 extends along the first direction X. It should be noted that, to reduce stress of the positive output copper bar 342, the groove 3420 extending along the first direction X may also be disposed on the positive output copper bar 342.

In this embodiment of this application, projections of the two positive output copper bars 342 and the one negative output copper bar 342 along the first direction may be all in an S shape or a U shape. Alternatively, projections of the two positive output copper bars 342 along the first direction are in an S shape, and a projection of the one negative output copper bar 342 along the first direction X is in a U shape. Alternatively, projections of the two positive output copper bars 342 along the first direction X are in a U shape, and a projection of the one negative output copper bar 342 along the first direction X is in an S shape. A connection end between the two positive output copper bars 342 and the one negative output copper bar 342 and the direct current input copper bar includes a welding section. The welding section and the direct current input copper bar 321 are stacked along the first direction and are fastened through laser welding, to implement an electrical connection between the capacitor module and the power module.

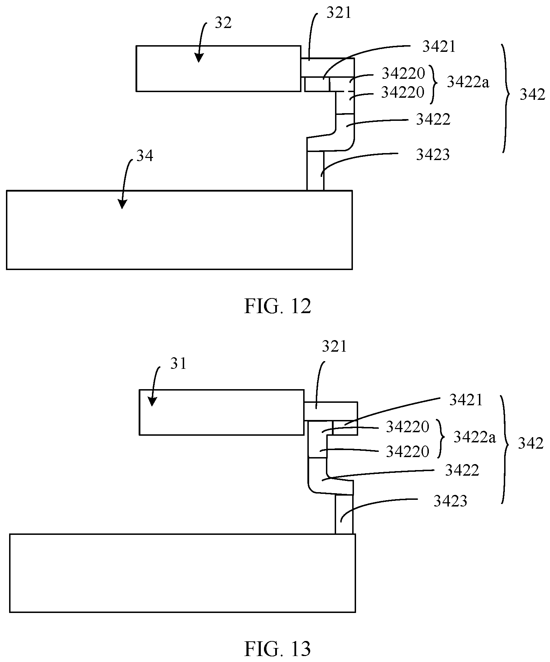

FIG. 12 is a side view of FIG. 11, and an insulation plate is not shown in FIG. 12. In an embodiment, the direct current output copper bar includes a welding section 3421, a lead-out section 3423, and a plurality of bent sections 3422 that are sequentially connected between the welding section 3421 and the lead-out section 3423, where the welding section 3421 is configured to electrically connect to one direct current input copper bar 321, and the lead-out section 3423 is configured to electrically connect to the capacitor core. Along the first direction X, a side surface that is of the one direct current input copper bar 321 and that faces the capacitor module 34 and a side surface that is of the welding section 3421 and that faces the one direct current input copper bar 321 are fastened through laser welding. It may be understood that one direct current output copper bar 342 and the welding section 3421 are stacked along the first direction, and the side surface that is of the direct current input copper bar 321 and that faces the capacitor module 34 is parallel to the side surface that is of the welding section 3421 and that faces the one direct current input copper bar 321, to reduce parasitic inductance.

In an embodiment, the plurality of bent sections 3422 include a first bent section 3422a, the first bent section 3422a includes two first connection sections 34220, one first connection section 34220 is configured to connect to the welding section 3421, and the other first connection section 34220 is configured to connect to another bent section 3422. An included angle between the one first connection section 34220 and the other first connection section 34220 faces one power module 32.

In an embodiment, an angle between the one first connection section 34220 and the other first connection section 34220 may be 90 degrees, the one first connection section 34220 and the other first connection section 34220 are vertically arranged, and the one first connection section 34220 is located along an extension direction of the welding section 3421 and is connected to the welding section 3421. At least a part of the one first connection section 34220 and the one direct current input copper bar 321 are stacked along the second direction. In a process of welding the one direct current output copper bar 342 and the one direct current input copper bar 321, at least the part of the one first connection section 34220 included in the one direct current output copper bar 342 may also be connected to the direct current input copper bar 321 through laser welding, thereby increasing a stacking length of the direct current output copper bar 342 and the direct current input copper bar 321, and further reducing parasitic inductance.

In an embodiment, an included angle between the one first connection section 34220 and the other first connection section 34220 faces one power module 32, and an angle of the included angle may be less than 90 degrees. A side surface that is of the one first connection section 34220, that is connected to the welding section 3421, and that faces the direct current input copper bar 321 and the side surface that is of the direct current input copper bar 321 and that faces the capacitor module 34 are stacked, and the other first connection section 34220 is connected to the one first connection section 34220 and extends to one side of the power module 32, thereby increasing an area in which the direct current output copper bar and the direct current input copper bar that are stacked along the first direction X, and further reducing parasitic inductance.

In the foregoing embodiment, an included angle of the another bent section 3422 faces one power module 32, and the included angle of the another bent section 3422 is greater than 90 degrees. A bending direction of at least one bent section 3422 in the plurality of bent sections 3422 is different from a bending direction of at least another bent section 3422 in the plurality of bent sections 3422. In this embodiment, it may be understood that a bending direction of the first bent section 3422a is opposite to the bending direction of the another bent section 3422, so that projections of the welding section 3421 and the plurality of bent sections 3422 of the direct current output copper bar 342 along the first direction are in a U shape, and an opening of the U shape faces the power module 32. The direct current output copper bar 342 includes a U-shaped bent portion with an opening facing the power module, so that parasitic capacitance can be reduced, and stress generated when the direct current output copper bar 342 and the direct current input copper bar 321 are connected through laser welding can be reduced, thereby improving stability of an electrical connection between the power module 32 and the capacitor module 34.

FIG. 13 is still another side view of matching between a capacitor module and a power module in a motor control unit according to an embodiment of this application. Refer to FIG. 13. A plurality of bent sections 3422 include one first bent section 3422a and another bent section 3422. The first bent section 3422a includes two first connection sections 34220, one first connection section 34220 is configured to connect to a welding section 3421, and the other first connection section 34220 is configured to connect to the another bent section 3422. An included angle between the one first connection section 34220 and the other first connection section 34220 faces away from one power module 32. A bending angle of the another bent section 3422 also faces away from the one power module 32, and a bending direction of the another bent section 3422 is opposite to a bending direction of the first bent section 3422a. In an embodiment, an angle that is between the one first connection section 34220 and the other first connection section 34220 and that faces away from the power module 32 is less than or equal to 90 degrees, and an included angle of the another bent section 3422 is greater than 90 degrees, to ensure that projections of the welding section 3421 and the plurality of bent sections 3422 included in the direct current output copper bar 342 along the second direction are in a U shape. An opening of the U shape faces away from one side of the power module 32. It may be understood that, the output copper bar 342 includes a U-shaped bent portion with an opening facing away from the power module 32, so that parasitic capacitance can be reduced, and stress generated when the direct current output copper bar and the direct current input copper bar are connected through laser welding can be reduced, thereby improving stability of an electrical connection between the power module 32 and the capacitor module 34.

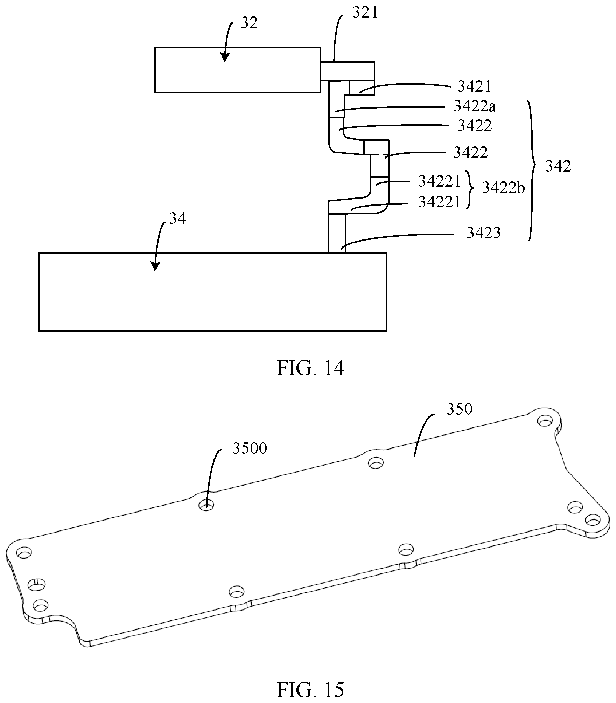

FIG. 14 is still another side view of matching between a capacitor module and a power module in a motor control unit according to an embodiment of this application. Refer to FIG. 13. A plurality of bent sections 3422 include a second bent section 3422b, the second bent section 3422b includes two second connection sections 34221, one second connection section 34221 is configured to connect to a lead-out section 3423, and the other second connection section 34221 is configured to connect to another bent section 3422. An included angle between the one second connection section 34221 and the other second connection section 34221 faces or faces away from a power module 32. As shown in FIG. 14, an included angle between the one second connection section 34221 and the other second connection section 34221 faces the power module 32, and an angle of the included angle is greater than 90 degrees. In an embodiment, the plurality of bent sections include two first bent sections 3422a and two second bent sections 3422b. One end of one first bent section 3422a is connected to a welding section 3421, and the other end is connected to the other first bent section 3422a. One end of one second bent section 3422b is connected to the lead-out section 3423, the other end is connected to the other second bent section 3422b, and the other second bent section is configured to connect to the other first bent section. Still refer to FIG. 10. Included angles of the second bent sections 3422b face the power module, and projections of the two second bent sections 3422b along the second direction are in a U shape with an opening facing the power module. Included angles of the two first bent sections 3422a face away from the power module, and projections of the two first bent sections 3422a along the second direction are in a U shape with an opening facing away from the power module. Projections of the two first bent sections 3422a and the two second bent sections 3422b along the second direction are approximately in an S shape.

In the foregoing embodiment, the projections of the two second bent sections 3422b along the second direction are in a U shape with an opening facing away from the power module, and the projections of the two first bent sections 3422a along the second direction are in a U shape with an opening facing the power module. The projections of the two first bent sections 3422a and the two second bent sections 3422b along the second direction are also approximately in an S shape.

Still refer to FIG. 4. The pressure plate component 35 is located between the power module 32 and the circuit board 33, and the pressure plate component 35 is connected to the middle separator 30 via the pressure plate fastener 301. In a process in which the pressure plate component 35 is connected to the middle separator 30 via the pressure plate fastener 301, the pressure plate component 35 presses the power module 32, so that stability of a connection between the power module 32 and the middle separator 30 is higher, and a problem of coolant leakage between the power module 32 and the middle separator 30 is prevented.

FIG. 15 is a diagram of a structure of a pressure plate in a motor control unit according to an embodiment of this application. Still refer to FIG. 4 and FIG. 15, the pressure plate component 35 includes a pressure plate 350 and an insulation paper 351. Along the first direction X, the pressure plate 350 is located on a side that is of the power module 32 and that faces away from the middle separator, and the insulation paper 351 is located between the pressure plate 350 and the circuit board 33. The pressure plate 350 includes a plurality of pressure plate fastening holes 3500, and the plurality of pressure plate fastening holes 3500 are distributed along an edge of the pressure plate 350. Along the first direction, a height of the pressure plate fastener is the same as a height of the power module 32 stacked on the middle separator, or the height of the pressure plate fastener is slightly less than the height of the power module 32 stacked on the middle separator, to ensure that after the pressure plate 350 is fastened to the middle separator, a position of the power module 32 along the first direction can be limited, and the power module 32 can be fastened to the middle separator, thereby preventing a problem of coolant leakage between the power module 32 and the middle separator. In an embodiment, some of the pressure plate fastening holes 3500 correspond to positioning holes included in the middle separator 30, and connecting pieces penetrate through the pressure plate fastening holes 3500 and are connected to the positioning holes, to improve fastening of the pressure plate 350 connected to the middle separator 30.

In this embodiment of this application, the insulation paper 351 may be fastened, through bonding, to a side that is of the pressure plate 350 and that faces the circuit board 33. Disposing of the insulation paper 351 helps reduce electrical interference between the power module 32 and the circuit board 33.

Still refer to FIG. 4. The Hall component 37 includes a Hall fastening plate 370. The Hall fastening plate 370 includes a plurality of connection holes, and the plurality of connection holes are configured to match the Hall supports 302, to fasten the Hall fastening plate 370 on the middle separator 30. The Hall fastening plate 370 has fastening portions configured to fasten a Hall magnetic core 371, and the plurality of fastening portions are spaced from each other along the second direction Y. Each Hall magnetic core 371 includes a magnetic core through hole, and the magnetic core through hole of each Hall magnetic core 371 is configured to allow one copper bar connecting piece 372 to penetrate. There is a gap between the copper bar connecting piece 372 and an inner wall of the magnetic core through hole. The copper bar connecting piece 372 is separately connected to the plurality of alternating current output copper bars 322 and the motor. A direct current transmitted by the capacitor module 34 is converted into an alternating current via the power module 32, and the alternating current is transmitted to the motor via the copper bar connecting piece 372.

In an embodiment, the copper bar connecting piece 372 may be connected to the alternating current output copper bar 322 via a connecting copper bar 373. Disposing of the connecting copper bar 373 can improve convenience of a connection between the copper bar connecting piece 372 and the alternating current output copper bar 322.

Still refer to FIG. 4. Circuit board fastening holes 330 are disposed at an edge of the circuit board 33. The circuit board supports 300 are inserted into the circuit board fastening holes 330 along the first direction X, to implement a fastened connection between the middle separator 30 and the edge of the circuit board 33. The middle separator 30 is fastened to the circuit board 33, so that positions of the power module 32 and the pressure plate component 35 that are located between the middle separator 30 and the circuit board 33 are also fixed, and displacements of the power module 32 and the pressure plate component 35 along the first direction are limited, so that an overall structure of the motor control unit 3 is stable. When an external environment exerts external force on the motor control unit 3, the power module and a press-fitting module do not easily move relative to each other inside the motor control unit. Correspondingly, the circuit board does not easily displace relative to the middle separator. This helps the motor control unit 3 to operate in a stable state. In an embodiment, a signal interface is disposed on the circuit board, and the signal interface is configured to be electrically connected to an external controller, and is configured to receive an external control signal to control the power module to convert a parameter of the alternating current.

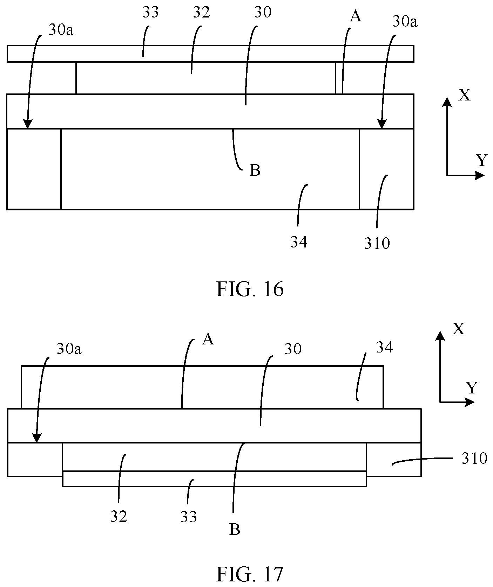

FIG. 16 is a main view of the circuit board 33, the plurality of power modules 32, the middle separator 30, the two coolant pipes 310, and the capacitor module 34 in FIG. 4. Refer to FIG. 3 and FIG. 11. The middle separator 30 includes an internal flow channel, two flow channel openings 30a, and two side surfaces that are distributed back to back. The two flow channel openings 30a are spaced from each other on a side surface B in the two side surfaces, and the two coolant pipes 310 are separately communicated with the internal flow channel through the two flow channel openings 30a. Along the first direction X, the plurality of power modules 32 are arranged between another side surface A of the circuit board 33 and the middle separator 30, the capacitor module 34 and the middle separator 30 are stacked, and the circuit board 33 is located on a side that is of the middle separator 30 and that faces away from the capacitor module 34.

According to the motor control unit provided in the foregoing embodiment of this application, the coolant enters the internal flow channel of the middle separator 30 through the two coolant pipes 310, and the internal flow channel can dissipate heat for the capacitor module 34 stacked with the middle separator 30, and dissipate heat for the power module 32 located between the another side surface A of the middle separator 30 and the circuit board 33. Along the second direction Y, the capacitor module 34 is located between the two coolant pipes 310, and the coolant in the two coolant pipes 310 can cool the capacitor module 34 located between the two coolant pipes 310, so that the capacitor module 34 quickly cools down. In this embodiment of this application, the middle separator 30 integrates a function of a heat sink. The middle separator 30 includes the Hall supports 302, the pressure plate fasteners 301, the installation windows 30b, and the circuit board supports 300. All components in the motor control unit are connected to the middle separator, so that integration of the motor control unit is higher, and miniaturization of the motor control unit is facilitated.

FIG. 17 is a main view of still another arrangement manner of a circuit board 33, a plurality of power modules 32, a middle separator 30, two coolant pipes 310, and a capacitor module 34 in a motor control unit according to an embodiment of this application. Refer to FIG. 17. The middle separator includes a side surface B and another side surface A, and the side surface B and the another side surface A are back to each other along the first direction X. The capacitor module, the middle separator, the power module, and the circuit board are stacked along the first direction, and the capacitor module 34 is located on the another side surface A of the middle separator. The middle separator 30 includes an internal flow channel and two flow channel openings 30a. Along the second direction Y, the two flow channel openings 30a are spaced from each other on the side surface B in the two side surfaces, and the two coolant pipes 310 are separately communicated with the internal flow channel through the two flow channel openings 30a.

In this embodiment, the coolant enters the internal flow channel of the middle separator 30 through the two coolant pipes 310, and the internal flow channel can dissipate heat for the capacitor module 34 stacked with the middle separator 30, and dissipate heat for the power module 32 located between the middle separator 30 and the circuit board 33. Along the second direction Y, the power module 32 is arranged between the two coolant pipes 310. The coolant in the two coolant pipes 310 can cool the power module 32 located between the two coolant pipes 310, so that the power module 32 quickly cools down. The middle separator 30 integrates a function of a heat sink, so that integration of the motor control unit is higher and miniaturization of the motor control unit is facilitated.

It should be noted that a height of the power module 32 is less than a height of the capacitor module 34. Along a height direction of the power module 32 and the capacitor module 34, a height of the coolant pipe 310 is greater than or equal to the height of the power module 32 or the capacitor module 34. The power module 32 is located between the two coolant pipes 310. Compared with that the capacitor module 34 is located between the two coolant pipes, that the power module 32 is located between the two coolant pipes 310 can shorten lengths of the coolant pipes along the power module 32 or the capacitor module 34, thereby reducing a thickness of the motor control unit along the height direction of the power module 32 or the capacitor module 34.

In addition, in the foregoing embodiments, the first direction X, the second direction Y, and the third direction Z may be perpendicular to each other. Perpendicularity defined in embodiments of this application is not limited to an absolute perpendicular intersection (an included angle is 90 degrees) relationship, a case in which an absolute perpendicular intersection relationship is not caused by factors such as an assembly tolerance, a design tolerance, and a structural flatness is allowed, and an error within a small angle range is allowed. For example, a relationship within an assembly error range of 80 degrees to 100 degrees may be understood as the perpendicular relationship.

It is clearly that, a person skilled in the art can make various modifications and variations to this application without departing from the scope of this application. This application is intended to cover these modifications and variations of this application provided that they fall within the scope of the claims of this application and equivalent technologies thereof.

## Claims

1. A motor control unit, wherein the motor control unit comprises a circuit board, a plurality of power modules, a middle separator, two coolant pipes, and a capacitor module, each power module comprises at least one power transistor, the circuit board is configured to control turn-on and turn-off of each power transistor, the middle separator comprises an internal flow channel and two flow channel openings, and the two coolant pipes are separately communicated with the internal flow channel through the two flow channel openings;
along a first direction, the plurality of power modules are arranged between the circuit board and the middle separator, the middle separator and the capacitor module are stacked, the middle separator comprises two side surfaces distributed back to back, and the two flow channel openings are spaced from each other on one side surface of the middle separator; and
along a second direction, the power module or the capacitor module is arranged between the two coolant pipes.

2. The motor control unit according to claim 1, wherein the middle separator comprises a plurality of installation windows, and each installation window is configured to fasten one power module and communicate with the internal flow channel; and
along the second direction, the plurality of installation windows are spaced from each other on the other side surface of the middle separator.

3. The motor control unit according to claim 2, wherein the middle separator comprises two rows of circuit board supports, the two rows of circuit board supports are configured to fasten the circuit board, and the two rows of circuit board supports are distributed on the other side surface of the middle separator; and
along a third direction, the two rows of circuit board supports are oppositely arranged on two sides of the plurality of installation windows.

4. The motor control unit according to claim 3, wherein the motor control unit comprises a pressure plate component, the middle separator comprises two rows of pressure plate fasteners, and the two rows of pressure plate fasteners are configured to fasten the pressure plate component and the middle separator;
along the first direction, the plurality of power modules are arranged between the pressure plate component and the middle separator; and
along the second direction, the two rows of pressure plate fasteners are distributed on the other side surface of the middle separator and are oppositely arranged on the two sides of the plurality of installation windows.

5. The motor control unit according to claim 3 or 4, wherein each row of circuit board supports comprises four circuit board supports; and
along the second direction, the four circuit board supports in each row of circuit board supports are spaced from each other, and a spacing between two adjacent circuit board supports is greater than an aperture of each installation window.

6. The motor control unit according to any one of claims 1 to 5, wherein each power module comprises a plurality of direct current input copper bars and one alternating current output copper bar, and each direct current input copper bar is configured to connect one power transistor and the capacitor module;
along the second direction, the plurality of direct current input copper bars are arranged; and along the third direction, the plurality of direct current input copper bars and the one alternating current output copper bar are respectively arranged on two sides of the power transistor.

7. The motor control unit according to any one of claims 1 to 5, wherein the motor control unit comprises a Hall component, the Hall component comprises a plurality of Hall sensors and a plurality of copper bar connecting pieces, and the plurality of Hall sensors are spaced from each other on the other side surface of the middle separator along the second direction; and
each Hall magnetic core comprises a magnetic core through hole, each magnetic core through hole is configured to allow one copper bar connecting piece to penetrate, and the copper bar connecting piece is configured to connect to the power transistor.

8. The motor control unit according to claim 7, wherein the Hall component comprises a Hall fastening plate, the Hall fastening plate is configured to fasten the plurality of Hall sensors, the middle separator comprises at least one row of Hall supports arranged along the second direction, the Hall supports are distributed on the other side surface of the middle separator, and the Hall supports are configured to fasten the Hall fastening plate.

9. The motor control unit according to any one of claims 1 to 8, wherein the capacitor module comprises a capacitor housing, a capacitor core, and a plurality of direct current output copper bars, the capacitor housing is configured to accommodate the capacitor core, and the plurality of direct current output copper bars are configured to electrically connect to the capacitor core and the power transistor; and
a projection shape of at least one direct current output copper bar along the first direction comprises an S shape or a U shape.

10. The motor control unit according to claim 9, wherein the direct current output copper bar comprises a welding section, a plurality of bent sections, and a lead-out section, and the plurality bent sections are sequentially connected between the welding section and the lead-out end; and
the welding section is configured to electrically connect to a direct current input copper bar of the one power module, a bending direction of at least one bent section in the plurality of bent sections is different from a bending direction of at least one bent section in the plurality of bent sections, and the lead-out section is configured to electrically connect to the capacitor core.

11. The motor control unit according to claim 10, wherein the plurality of bent sections comprise a first bent section, and the first bent section comprises two first connection sections; and
one first connection section is configured to connect to the welding section, the other first connection section is configured to connect to another bent section, and an included angle between the one first connection section and the other first connection section faces or faces away from the one power module.

12. The motor control unit according to claim 10, wherein the welding section and the one first connection section are separately stacked with one direct current input copper bar along the first direction.

13. The motor control unit according to any one of claims 8 to 12, wherein the plurality of bent sections comprise a second bent section, and the second bent section comprises two second connection sections; and
one second connection section is configured to connect to the lead-out section, the other second connection section is configured to connect to another bent section, and an included angle direction between the one second connection section and the other second connection section faces or faces away from the one power module.

14. A powertrain, wherein the powertrain comprises a motor and the motor control unit according to any one of claims 1 to 13, and the motor control unit is configured to drive the motor.

15. A vehicle, wherein the vehicle comprises a motor and the motor control unit according to any one of claims 1 to 13 for driving the motor, or comprises the powertrain according to claim 14; and
the motor or the powertrain is configured to drive the vehicle.
